(19) Europäisches Patentamt
European Patent Office
Office européen des brevets

(11) **EP 4 167 031 A1**

(12) **EUROPEAN PATENT APPLICATION**

(43) Date of publication:
**19.04.2023 Bulletin 2023/16**

(21) Application number: **21203273.4**

(22) Date of filing: **18.10.2021**

(51) International Patent Classification (IPC):
**G03F 9/00** (2006.01)    **G03F 7/20** (2006.01)

(52) Cooperative Patent Classification (CPC):
**G03F 9/7046; G03F 7/70616; G03F 7/70633;
G03F 9/7019; G03F 9/7053**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **GOORDEN, Sebastianus, Adrianus
5500 AH Veldhoven (NL)**
• **HUISMAN, Simon, Reinald
5500 AH Veldhoven (NL)**
• **MATHIJSSEN, Simon, Gijsbert, Josephus
5500 AH Veldhoven (NL)**

(74) Representative: **ASML Netherlands B.V.
Corporate Intellectual Property
P.O. Box 324
5500 AH Veldhoven (NL)**

(54) **METHOD OF DETERMINING A MEASUREMENT RECIPE IN A METROLOGY METHOD**

(57) Disclosed is a method for determining a measurement setting for measuring a parameter of interest from a target structure on a substrate. The method comprises: obtaining first position difference data describing a difference between a position of a first representative target structure position and a position of one or more first features relating to product structure; obtaining optical metrology data relating to optical measurements of said target structure and further relating to a plurality of different measurement settings; and determining said measurement setting from said first position difference data and said optical metrology data such that a measured feature position value obtained from an optical measurement of said target structure using the determined measurement setting is better correlated to a position of said one or more first features.

Fig. 4

**Description**

FIELD OF THE INVENTION

The present invention relates to methods and apparatus usable, for example, in the manufacture of devices by lithographic techniques, and to methods of manufacturing devices using lithographic techniques. The invention relates more particularly to metrology sensors and lithography apparatuses having such a metrology sensor.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In some metrology applications, such as in some scatterometers or alignment sensors, imperfections in metrology targets can result in a wavelength/polarization dependent variation in a measured value from that target. As such, mitigation for this variation is sometimes effected by determining a "measurement recipe" for the measurement (e.g., in a calibration phase for a particular application), where a measurement recipe may describe a particular illumination condition (e.g., wavelength and polarization combination) and/or measurement parameter weighting for which alignment accuracy is optimized.

It would be desirable to improve methods for determining such a measurement recipe.

SUMMARY OF THE INVENTION

The invention in a first aspect provides a method for determining a measurement setting for measuring a parameter of interest from a target structure on a substrate; the method comprising: obtaining first position difference data describing a difference between a position of a first representative target structure position and a position of one or more first features relating to product structure; obtaining optical metrology data relating to optical measurements of said target structure and further relating to a plurality of different measurement settings; and determining said measurement setting from said first position difference data and said optical metrology data such that a measured feature position value obtained from an optical measurement of said target structure using the determined measurement setting is expected to represent a position of said one or more first features.

Also disclosed is a computer program, alignment sensor and a lithographic apparatus being operable to perform the method of the first aspect.

The above and other aspects of the invention will be understood from a consideration of the examples described below.

BRIEF DESCRIPTION OF THE DRAWINGS

Embodiments of the invention will now be described, by way of example only, with reference to the accompanying drawings, in which:

Figure 1 depicts a lithographic apparatus;
Figure 2 illustrates schematically measurement and exposure processes in the apparatus of Figure 1;
Figure 3 is a schematic illustration of an alignment sensor adaptable according to an embodiment of the invention;
Figure 4 conceptually illustrates the problem of product structure position correlating with different parts of an alignment mark which acts as a proxy for the product structure while being measurable using an optical metrology device such as illustrated in Figure 3; it shows (a) the product structure position being correlated to the top of the alignment mark and (b) the product structure position being correlated to the bottom of the alignment mark;

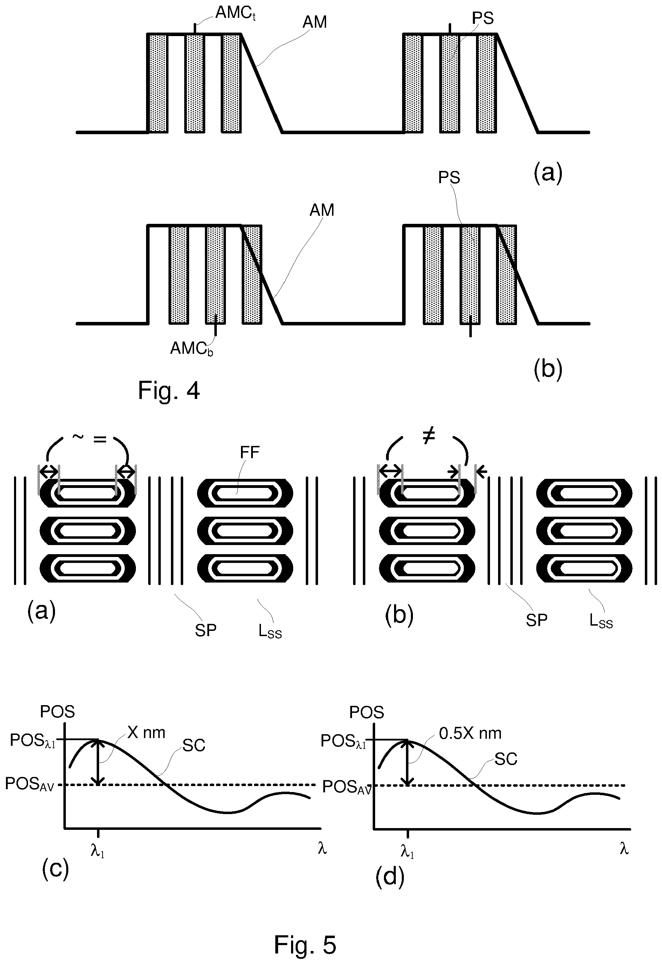

Figure 5 is a schematic illustration of a first example sub-segmented target usable in method (a) without any asymmetry due to a shift of a sub-segmentation feature representing a first features (b) with asymmetry due to a shift of a sub-segmentation feature representing a first features; and (c) a first swing curve for a mark with first difference between a first representative target structure position and a position of one or more first features relating to product structure and (d) a second swing curve for a mark with second difference between a first representative target structure position and a position of one or more first features relating to product structure; and
Figure 6 is a schematic illustration of a second example sub-segmented target usable in method (a) without any asymmetry due to a shift of a sub-segmentation feature representing a first features and (b) with asymmetry due to a shift of a sub-segmentation feature representing a first features.

DETAILED DESCRIPTION OF EMBODIMENTS

Before describing embodiments of the invention in detail, it is instructive to present an example environment in which embodiments of the present invention may be implemented.

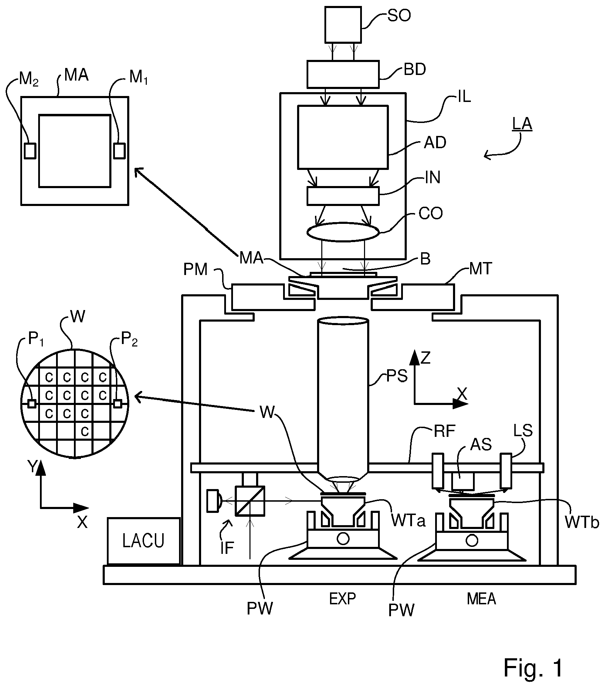

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device).

Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

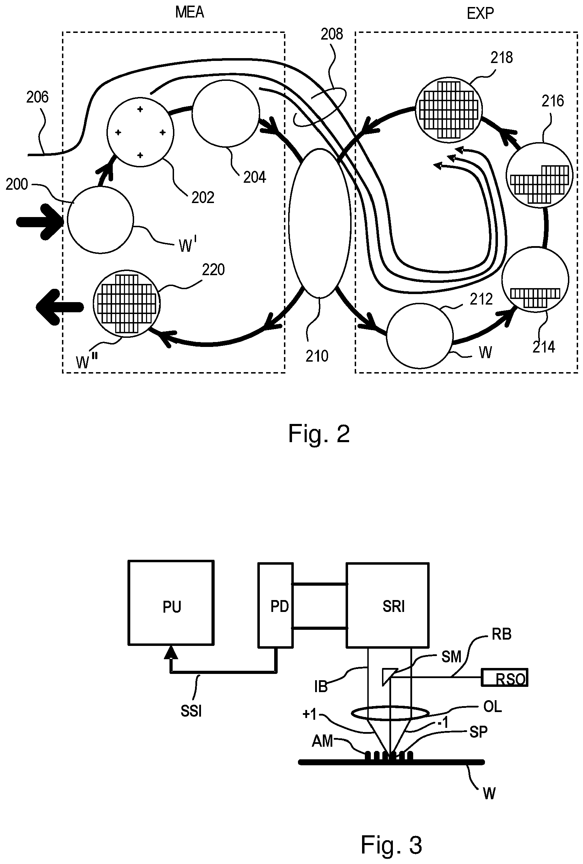

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

A mark, or alignment mark, may comprise a series of bars formed on or in a layer provided on the substrate or formed (directly) in the substrate. The bars may be regularly spaced and act as grating lines so that the mark can be regarded as a diffraction grating with a well-known spatial period (pitch). Depending on the orientation of these grating lines, a mark may be designed to allow measurement of a position along the X axis, or along the Y axis (which is oriented substantially perpendicular to the X axis). A mark comprising bars that are arranged at +45 degrees and/or -45 degrees with respect to both the X- and Y-axes allows for a combined X- and Y- measurement using techniques as described in US2009/195768A, which is incorporated by reference.

The alignment sensor scans each mark optically with a spot of radiation to obtain a periodically varying signal, such as a sine wave. The phase of this signal is analyzed, to determine the position of the mark and, hence, of the substrate relative to the alignment sensor, which, in turn, is fixated relative to a reference frame of a lithographic apparatus. So-called coarse and fine marks may be provided, related to different (coarse and fine) mark dimensions, so that the alignment sensor can distinguish between different cycles of the periodic signal, as well as the exact position (phase) within a cycle. Marks of different pitches may also be used for this purpose.

Measuring the position of the marks may also provide information on a deformation of the substrate on which the marks are provided, for example in the form of a wafer grid. Deformation of the substrate may occur by, for example, electrostatic clamping of the substrate to the substrate table and/or heating of the substrate when the substrate is exposed to radiation.

Figure 3 is a schematic block diagram of an embodiment of a known alignment sensor AS. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include complementary higher diffracted orders; e.g.,: +1 and -1 diffracted orders (labelled +1, -1) and optionally zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

SRI Intensity signals SSI are supplied to a processing unit PU. By a combination of optical processing in the self-referencing interferometer SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels are repeated at different wavelengths ("colors") for increased accuracy and/or for robust detection of the mark irrespective of the materials from which the mark is made, and materials on and/or below which the mark is provided. Improvements in performing and processing such multiple wavelength measurements are disclosed below.

Other types of alignment sensor may comprise image-based alignment sensors which determine alignment from an acquired image of an interference pattern from illumination scattered by an alignment mark. A specific type of image-based metrology sensor, which as both alignment and product/process monitoring metrology applications is described in PCT patent application WO 2020/057900 A1, which is incorporated herein by reference. This describes a metrology device with optimized coherence. More specifically, the metrology device is configured to produce a plurality of spatially incoherent beams of measurement illumination, each of said beams (or both beams of measurement pairs of said beams, each measurement pair corresponding to a measurement direction) having corresponding regions within their cross-section for which the phase relationship between the beams at these regions is known; i.e., there is mutual spatial coherence for the corresponding regions. These beams of each beam pair are interfered on a detector (e.g., a camera/CCD array) such that the interference pattern is imaged.

Such a metrology device is able to measure small pitch targets with acceptable (minimal) interference artifacts (speckle) and will also be operable in a dark-field mode. Such a metrology device may be used as a position or alignment sensor for measuring substrate position (e.g., measuring the position of an alignment mark by measuring the interference fringe position of the interference image with respect to a fixed reference position). The metrology device is also usable for measurement of overlay (e.g., measurement of relative position of periodic structures in different layers, or even the same layer in the case of stitching marks). The metrology device is also able to measure asymmetry in periodic structures, and therefore could be used to measure any parameter which is based on a target asymmetry measurement (e.g., overlay using diffraction based overlay (DBO) techniques or focus using diffraction based focus (DBF) techniques).

In the context of wafer alignment, the following approaches are in use or have been proposed to determine a measurement recipe (comprising settings of the alignment measurement system such as the color and/or polarization mode of the radiation provided by the radiation source RSO) which mitigates mark asymmetry (asymmetry in the alignment mark which results in a position error or offset):

- Selecting a "default" color or color combination of the radiation provided by the radiation source RSO;
- Selecting a color or color combination that is expected to provide an accurate position value based on experience with previous nodes, layers or comparable layer stacks and/or mark characteristics (such as its sub-segmentation, which refers to division of mark features into smaller pitch features closer to the actual pitch of product features).
- Selecting a color or color combination that is expected to provide an accurate position value based on simulations (e.g., of the stack and interaction of radiation with(in) the stack; not necessarily including a full sensor model);
- Selecting a color or color combination for which the signal strength is high and/or a (mark-level) signal correlates well to the expected signal (e.g. signal is sinusoidal);
- Selecting a color or color combination such that the resulting aligned position is consistent with other colors;
- Selecting a color or color combination such that, after fitting a model ((wafer model) to the alignment positions, the wafer-level residuals are minimized. The wafer model may be assumed to contain fewer free parameters than the number of marks measured;
- Selecting an average color; or signal-strength-weighted average over many colors; or a small subset of only one or a few (weighted) colors such that the result is consistent with signal-strength-weighted average over a larger set of colors (where the larger set of colors may be measured infrequently or only during recipe setup).

Other more comprehensive approaches include: OCW (Optimal Color Weighing- described in more detail in US publication US2019/0094721 A1 which is incorporated herein by reference) and OCIW (Optimal Color and Intensity Weighing - described in more detail in PCT publication WO 2017032534 A2). In each of these cases, training to reference data is needed or desired. This means that these corrections can only be accurately performed if sufficient training data is available and if the process variations in the training data are representative for the variations (for example in plane deformations) in the wafers that need to be corrected. This reference data may be measured by a reference sensor, e.g. overlay data (e.g., after-develop or pre-etch overlay data). Potential disadvantages of these approaches include: a first set of wafers may be exposed based on a sub-optimal recipe; expose errors in a new layer N may impact the recipe for aligning on the mark in a previous layer M; the recipe is subject to measurement inaccuracies of the reference sensor, leading to potentially sub-optimal on-product overlay (OPO) and consequently may impact the quality of the reference data (and its derived optimal colors).

In each case (and throughout this specification) any reference to color includes polarization (e.g. a color/polarization combination).

To address this, it has been proposed to use a dispersion model(s) and/or dispersion equation(s) and/or dis-

person approximation(s), such as the Forouhi-Bloomer dispersion equation(s)/approximation(s), a Lorentz oscillator based dispersion model, one or more Kramers-Kronig dispersion relations and/or one or more Plemelj dispersion relations, to convert measured intensity asymmetry information (typically measured for a limited number of wavelengths) in a position correction for mark asymmetry. Such methods are disclosed in WO2021/122016, which is incorporated herein by reference and are referred to herein as Kramers-Kronig based methods. Such methods may comprise mathematically calculating the intensity asymmetry value into a phase offset value corresponding to mark asymmetry (e.g., calculating the phase offset from intensity asymmetry using physics principles). In a recent paper, "A fast Fourier transform implementation of the Kramers-Kronig relations: Application to anomalous and left handed propagation, Lucas et al AIP Advances 2, 032144 (2012)" (incorporated herein by reference), the Kramers-Kronig relations have been derived from simple causality considerations. Taking this teaching and applying it to complex fields coming from an alignment mark, a phase offset $\Delta\varphi$ and therefore position error (APD) $\Delta x$ of an alignment mark can be expressed solely in terms of the measured intensities:

$$\Delta\varphi = \frac{1}{2}(Im(\mathrm{H}_T(\log(E_{+1}E_{+1}{}^*) - \log(E_{-1}E_{-1}{}^*))))$$

$$\Delta x = \frac{P}{8\pi n}(Im(\mathrm{H}_T(\log(I_{+1}) - \log(I_{-1}))))$$

where $\mathrm{H}_T$ is the Hilbert transform and $E_-$, $E_+$ are electric fields of the +1 and -1 captured diffraction orders respectively and $I_{+1}$, $I_{-1}$ are the intensities corresponding to the electric fields: see sections II.A and II.B from the aforementioned Lucas article. Note the Im() operator is not essential, it is added to suppress numerical noise.

Based on this, it is possible to compute an expected alignment position error based on intensity asymmetries measured on that specific alignment mark for a number of different illumination conditions using a metrology tool (e.g., the alignment sensor or other offline metrology tool), and selecting a preferred illumination condition based on a plot of measured alignment position vs illumination condition (alignment swing curve); e.g., an illumination condition with a low measured alignment position error and small gradient (low error within a stable region).

WO2021/122016 further discloses a method of determining a position correction and therefore a corrected position, which comprises the steps of:

1) obtaining intensity asymmetry data from one or more measurements of the alignment mark (e.g., for multiple wavelengths).

2) Obtaining dispersion model(s) and/or dispersion equation(s) and/or dispersion approximation(s), to the measured intensity asymmetry; e.g., where the dispersion models take the form of:

$$\varepsilon_{r+}(\omega) = 1 + c_{re+} - i \cdot \sum_{m+=1}^{M} \frac{a_{m+}}{i \cdot \omega - b_{m+}} - \frac{a_{m+}^*}{i \cdot \omega - b_{m+}^*}$$

$$\varepsilon_{r-}(\omega) = 1 + c_{re-} - i \cdot \sum_{m-=1}^{M} \frac{a_{m-}}{i \cdot \omega - b_{m-}} - \frac{a_{m-}^*}{i \cdot \omega - b_{m-}^*}$$

and fitting these according to:

$$\ln|E_+(\omega)| - \ln|E_-(\omega)| = -\omega \cdot \sqrt{\varepsilon_0 \cdot \mu_0} \cdot \left(\mathrm{Im}\left(\sqrt{\varepsilon_{r+}}\right) \cdot d_+ - \mathrm{Im}\left(\sqrt{\varepsilon_{r-}}\right) \cdot d_-\right)$$

such that the intensity asymmetry is converted to an amplitude asymmetry (e.g., difference in amplitudes of the electric field $E_+(\omega)$, $E_-(\omega)$) by means of a root operation, $\omega$ is the angular frequency, $\varepsilon_0$ is the permittivity constant, $\mu_0$ is the permeability constant and $\varepsilon_r$ is the complex effective dielectric permittivity dispersion function described by the dispersion model, $c_{re}$ is the real offset constant, $a_m$ is the dipole complex amplitude, $i$ is the imaginary unit

$(= \sqrt{-1})$ and $b_m = -\varsigma_m \cdot \omega_m + \omega_m \cdot \sqrt{\varsigma_m^2 - 1}$, where $\omega_m$ dipole natural eigen-frequency and $\zeta_m$ is the dipole

sampling constant $(0 < \zeta_m < 1)$ ( $\frac{1}{\varsigma_m \cdot \omega_m}$ is the dipole time constant).

3) computing, using the fitted dispersion model, an equivalent phase offset $\Delta\varphi(\omega)$ for the intensity asymmetry and therefore a position correction $\Delta x(\omega)$:

$$\Delta x(\omega) = \frac{P}{4\pi n} \cdot \Delta\varphi(\omega)$$

Where:

$$\Delta\varphi(\omega) = \arg\big(E_+(\omega)\big) - \arg\big(E_-(\omega)\big)$$
$$= -\omega \cdot \sqrt{\varepsilon_0 \cdot \mu_0} \cdot \big(\mathrm{Im}\big(\sqrt{\varepsilon_{r+}}\big) \cdot d_+ - \mathrm{Im}\big(\sqrt{\varepsilon_{r-}}\big) \cdot d_-\big)$$

Where P is the mark pitch and $n \in \{1,2,3, \dots\}$ is the diffraction order,. Note that (when using the dispersion models as described) all poles occur as (conjugated) pole pairs (dipoles), where M denotes the total number of pole pairs. Note that one of the two dispersion models $\varepsilon_{r+}(\omega)$ and $\varepsilon_{r-}(\omega)$ for the positive respectively negative diffraction order(s), may be kept constant and/or set to zero.

It should be noted that the real offset constant $c_{re+}$, $c_{re-}$ is an unobservable parameter in the model. However, it is known that when the (diffraction order) amplitude asymmetry is zero for all wavelengths, the position correction will be zero. Hence the parameters $c_{re+}$, $c_{re-}$ will be equal. Their common/equal value (which is constant over time) is typically larger than zero, and this value may be best 'fitted' to the measured data obtained from the measurements of all available wavelengths.

Alignment sensors typically can only resolve periodic structures (alignment marks or alignment gratings) having a suitably large pitch, which may be orders of magnitude larger than feature sizes (e.g., critical dimensions) of the actual product features (structures). Alignment measurements measure the position of the alignment mark. However, the alignment mark position does not necessarily correlate with the position of product structures, while it is the position of product structures which is critical. Alignment marks are also subject to unwanted asymmetries which vary from mark to mark and which result in a measured alignment error. In overlay metrology particularly, a concept of metrology-to-device (MTD) offset is known. This comprises determining a correction as a single constant which corrects for an alignment sensor's different response to a metrology target compared to its response to the (smaller) product structure. However, such a prior art MTD offset is unaware of and cannot take into consideration any mark-to-mark or wafer-to-wafer variation such as grating asymmetry, and how these variations correlate with product position. Therefore it is not possible presently to set up a measurement recipe such that the measured position correlates with product feature position and therefore minimizes OPO.

Figure 4 illustrates the problem of using an alignment mark which is subject to a grating asymmetry as a proxy for product structure. In each of Figures 4(a) and 4(b), an alignment mark having a profile as illustrated by line AM is shown overlaid with the profile of product structure PS for which it acts as a measurement proxy. It is the position of the product structure which is of importance, this being inferred from measurement of the alignment mark in, for example, a high volume manufacturing setting. In Figure 4(a), corresponding to a first process, the position of the product structure PS (shaded) correlates with the top of the alignment mark AM, (where the center of the top of the mark is labeled $AMC_t$). In Figure 4(b), corresponding to a second process, the position of the product structure PS correlates with the bottom of the alignment mark AM (where the center of the bottom of the mark is labeled $AMC_b$). In other processes, the position of the product structure may correlate with an intermediate level of the alignment mark. In each case, the alignment mark is identical and therefore present alignment set-up methods (such as present color weighting or Kramers-Kronig based methods) that only have access to measurement signals measured on the alignment mark, and do not in use information on which process is used, will always return an identical measurement position for e.g., each of the cases illustrated by Figures 4a and 4b. However, it is clear that the returned aligned position can only be "correct" (i.e., correlate to the product position) in at most one of these cases.

Present alignment set-up methods (such as present color weighting or Kramers-Kronig based methods) for determining an alignment measurement recipe will typically yield an incorrect position value as these methods often optimize for an alignment mark's "center of mass" (e.g., an average position of the alignment mark) for example, which is often poorly correlated with the true product feature position. When grating asymmetry varies, the difference between the measured aligned position and the product feature position varies, which negatively impacts OPO.

It is therefore proposed to use first position difference data describing a difference between a first representative alignment mark position and a product structure position in a measurement recipe set-up phase. Such first position difference data may be measured using, for example, a scanning electron microscope (SEM), transmission electron microscope (TEM) or any metrology tool with sufficient resolution to measure the product structure position(s), or may be obtained through process knowledge. The product structure position(s) may relate to any one or more first features (e.g., a critical feature having a small process window or latitude in positioning). The first representative alignment mark position may relate to a center of mass (e.g., a center of an alignment mark, alignment mark line) or an average position of two or more features of the alignment mark. The first position difference data may be obtained from the respective positions of first representative alignment mark positions and a product structure position obtained from the same image, or at least without any intervening process steps between formation of the structures being measured. The product structure position may relate to a portion of the alignment mark, where the alignment mark is sub-segmented with product or product-like structures. As such, the first position difference may be a difference between a position of a (product or product-like) first features (whether part of the alignment mark or otherwise) with respect to a representative position of the alignment mark.

The method may comprise determining a measurement recipe which minimizes a difference between second position difference data from optical measurements of the alignment target and said first position difference data. The second position difference data may comprise a difference between a measured position obtained using the determined measurement recipe with a second representative alignment mark position.

The second representative alignment mark position may comprise an average measured position for a number of different illumination conditions or a measured position obtained using Kramers-Kronig methods (either directly inferred position using Kramers-Kronig methods or with a measurement recipe optimized using Kramers-Kronig methods). The second representative alignment mark position may correspond to a center of mass of the alignment mark. The second representative alignment mark position may comprise an average position when using all available colors and/or all available polarizations individually and/or for a number of different combinations of colors/polarizations. In an embodiment, a swing curve (measured position against wavelength) may be constructed with the second representative alignment mark position being the average position of this swing curve. Respective such swing curves may be constructed for each of different polarizations, with the second representative alignment mark position being an average of the average positions from the different swing curves. In other embodiments, the second representative alignment mark position may comprise an average position measured with only a subset of available illumination conditions (e.g., it may be known which illumination conditions will provide a suitable range to average). Where intensity channels are not available, the average weighted position may comprise a signal strength weighted average measured position.

In an embodiment, the measurement recipe, in addition to or as an alternative to providing a weighting for illumination conditions and/or determining which one or more wavelengths/polarizations to use, may describe an intensity weighting, e.g., a weighting for particular regions or pixels of a measurement image. As such, when using an image based metrology tool, an image of whole mark can be acquired which will reveal intensity variation within the mark (e.g., edge of mark versus center of mark). A weighting can then be determined for individual pixels, or groups of pixels, so as to weight different parts of the mark such that the difference between the second position difference data and first position difference data is minimized, and such that its aligned position correlates better to the image position of one or more first features.

In an embodiment, the alignment mark may be a sub-segmented mark, comprising product or product-like sub-segmentation. As such, the main features of the alignment mark (e.g., the alignment mark lines) may comprise and/or be comprised of such product or product-like features. Product-like features may comprise features of a similar spatial scale (similar dimensions) and which behave similarly to product structures when measured and processed etc.. The product or product-like features are too small to be resolved by the alignment sensor, which will effectively "see" only a normal alignment mark. However, a change in the product or product-like feature will typically result in a change in e.g., a position swing curve (i.e., measured aligned position as function of color and polarization). Other embodiments may comprise measuring a conventional alignment mark and neighboring product or product-like features to determine the first position difference data.

A first specific example will be described in combination with Figure 5. Figure 5(a) illustrates a first sub-segmented alignment mark structure, showing a detail of two adjacent sub-segmented lines Lss formed by the oval shaped compound features separated by a single space SP (which comprises vertical line features having a CD too small to be resolved by the sensor). In this specific example, the first features FF are the center white oval shaped features; it known for this example that the product structure correlates with the position of this first features FF. This alignment mark may be formed specifically for the purposes of alignment, it may comprise a component part of another metrology target (e.g., it may be a bottom grating of an overlay target) or else it may be an actual functional product structure.

Figure 5(a) shows an example where the first features FF are positioned optimally such that it is centered with respect to the remainder of the alignment mark. This means (assuming no other defects) that the alignment mark is symmetrical. In real world situations, there will be wafer to wafer variation in mark asymmetry. In particular, the position of the first features FF may vary with the rest of alignment mark; this being a form of mark asymmetry. This is illustrated in Figure 5(b).

In this specific example, the first position difference data may comprise the difference in the position of the first features with respect to the position of the remainder of the alignment mark (e.g., one or more other features of the alignment mark). It may be known, for example, that alignment measurements on the mark based on using vertically polarized radiation will correlate with the positions of the vertical lines, while alignment measurements on the mark based on using horizontally polarized radiation will correlate with the position of the first features. In such an example, the second representative alignment mark position may comprise an average of the positions obtained when measured using vertically polarized and horizontally polarized radiation respectively. The recipe optimization can then determine one or more weights for the vertically polarized and horizontally polarized radiation (and/or colors and/or pixels etc..) using the methods described, such that the position reported by the optical alignment measurement is representative of the position of the first features FF.

As an alternative embodiment, variation in optical color response may be used instead of polarization response (e.g., physical insight of which polarizations correlate with which features is not required). For example, the first position difference data (measured with e.g., an SEM) may indicate that there is X nm of displacement between the first features (e.g., product structure) and the first representative alignment mark position (e.g. center-of-mass of the mark). Optical measurements over multiple colors of the same (or similar) mark may yield a measured swing curve (aligned position as function of color) showing a variation in the color response, in which some colors correlate more strongly to the first features position than other colors. A second representative alignment mark position may be determined, for example by averaging over all colors. The chosen recipe may comprise one or a few weighted colors selected such that the aligned position of these one or a few weighted colors with respect to the center-of-gravity is equal to X nm displacement determined from the first position difference data).

Figure 5(c) illustrates a first such example, showing an example swing curve SC and second representative alignment mark position $POS_{AV}$ on a plot of position POS against wavelength $\lambda$. In this example, the difference between the aligned position $POS_{\lambda 1}$ at a particular single wavelength $\lambda_1$ and the second representative alignment mark position $POS_{AV}$ happens to be the same as the first position difference X nm. Therefore, an appropriate recipe for this alignment mark may be simply using only the color $\lambda_1$ (i.e., with a weighting of 1). However, in Figure 5(d), the same plot is shown, but here the difference between the aligned position $POS_{\lambda 1}$ at wavelength $\lambda_1$ and the second representative alignment mark position $POS_{AV}$ is 0.5X nm. In this approach an appropriate recipe may comprise a weighting of 2 for this wavelength $\lambda_1$ (or a suitable weighted combination of two or more other wavelengths).

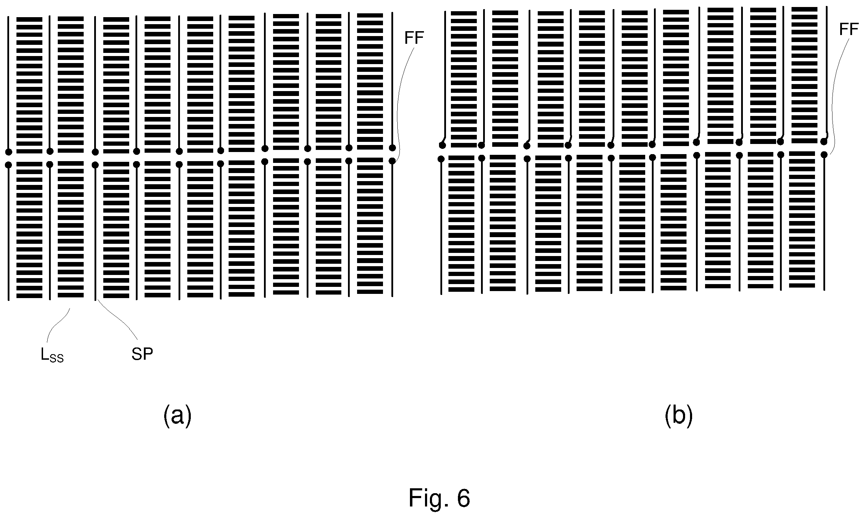

A second specific example will be described in combination with Figure 6. Here the first features FF are at the top of the contact holes, and therefore it is the position of these features which is wanted when performing alignment. In Figure 6(a) the top of the contact holes are shown aligned and in Figure 6(b) the top of the contact holes are shown misaligned as a result of tilt variation (e.g., as may be caused by etch tilt resultant from etching of the bottom layer stack, including product and alignment mark). This again is a form of mark asymmetry which varies from wafer-to-wafer. It should be noted that at the time that the alignment measurement is performed, the top layer has not been etched. It is known that alignment measurement at some measurement wavelengths will tend to correlate with the top of the stack and other wavelengths will tend to correlate with the bottom of the stack. How the various colors and polarizations exactly correlate to the product feature within the mark and to the rest of the mark (e.g. optical center-of-gravity) can be determined by measuring a swing curve (aligned position as function of color and polarization) on one or multiple marks and on one or few wafers. Alternatively, this may be understood from physical insights, experience and/or simulations. In an embodiment, a color weighting may be optimized which weights two or more wavelengths such that the measured position correlates with the top of the stack, and more specifically with the top of the contact holes. It may be that the optimization determines that a single unweighted optimized wavelength is optimal (e.g., where the single wavelength measurement correlates well with the contact hole top position).

As such, a method is described which enables a measurement recipe to be determined which improves alignment accuracy with respect to one or more product first features, in the presence of variable alignment mark asymmetry. The proposed method does not require any measurements to be performed after exposure (e.g., no hindsight overlay metrology is required).

While the above description has concentrated on alignment metrology, the concepts disclosed herein are not so limited. The measurement recipe optimization methods disclosed herein are also applicable to other metrology applications subject to unwanted target asymmetries which vary from wafer-to-wafer, e.g., measuring other parameters of interest such as overlay. Overlay targets comprise gratings which may be subject to grating asymmetry (e.g., bottom grating asymmetry) which cause overlay errors and variation in the measured overlay position for different illumination conditions (or more generally: measurement recipes).

Further embodiments are disclosed in the list of numbered clauses below:

1. A method for determining a measurement setting for measuring a parameter of interest from a target structure on a substrate; the method comprising: obtaining first position difference data describing a difference between a position of a first representative target structure position and a position of one or more first features relating to a product structure; obtaining optical metrology data relating to optical measurements of said target structure and further relating to a plurality of different measurement settings; and determining said measurement setting from said first position difference data and said optical metrology data such that a measured feature position value obtained from an optical measurement of said target structure using the determined measurement setting is expected to represent a position of said one or more first features.

2. A method according to clause 1, wherein said first position difference data is obtained from direct measurement of said first representative target structure position and said position of one or more first features.

3. A method according to clause 2, wherein said first position difference data comprises scanning electron microscope data and/or transmission electron microscope data.

4. A method according to clause 1, 2 or 3, comprising performing first metrology on at least one substrate comprising a plurality of instances of said target structure to obtain said first position difference data.

5. A method according to any preceding clause, wherein said first representative target structure position describes a center of mass position target structure, center position of the target structure, other feature position of the target structure or an average position of two or more features of the target structure.

6. A method according to any preceding clause, wherein said target structure comprises a sub-segmented target structure having a periodicity of sufficient magnitude to be resolvable by an optical metrology tool; and Sub-segmentation comprising and/or being representative of said one or more first features.

7. A method according to clause 6, wherein said first position difference data comprises measurements of a difference between a position of said sub-segmentation comprising and/or being representative of said one or more first features and said first representative target structure position.

8. A method according to any preceding clause, wherein said step of determining a measurement setting comprises determining said measurement setting to minimize a difference between second position difference data obtained from said optical metrology data and said first position difference data, wherein the second position difference data comprises a difference between a measured position obtained using the determined measurement setting with a second representative target structure position.

9. A method according to clause 8, wherein said second representative target structure position comprises an average measured position over a plurality of different measurement settings.

10. A method according to clause 9, wherein said average weighted position comprises a signal strength weighted average measured position.

11. A method according to clause 8, wherein said second representative target structure position is obtained by: obtaining a plurality of intensity asymmetry values for each of a plurality of different illumination settings, wherein an intensity asymmetry value comprises a metric related to a difference or imbalance between the respective intensities or amplitudes of at least two complementary diffraction orders of radiation diffracted by said structure; translating the intensity asymmetry value into a phase offset corresponding to asymmetric deviation in the alignment structure; and

determining, from the phase offset, said second representative target structure position as a position corrected for said asymmetric deviation.

12. A method according to clause 11, wherein said translating step comprises:
fitting at least one dispersion model to the intensity asymmetry measurement to obtain a fitted dispersion model, the dispersion model comprising a model of the structure as a transmission function; and determining said phase offset from the fitted dispersion model.

13. A method according to any of clauses 8 to 12, wherein said second representative target structure position corresponds to a center of mass or center position of the target structure.

14. A method according to any preceding clause, wherein each measurement setting comprises one or more of: an illumination setting, where an illumination setting describes one or a combination of measurement wavelengths and/or one or a combination of measurement polarizations;

a weighting for one or a plurality of measurement wavelengths and/or measurement polarizations;
and/or a weighting for particular regions, pixels or groups of pixels of a measurement image.

15. A method according to any preceding clause, wherein said first position difference data and said optical metrology data all relate to metrology performed before an exposure step, the method not using any hindsight overlay metrology.

16. A method according to any preceding clause, comprising using the determined measurement setting to determine a parameter of interest value comprising and/or relating to said measured feature position value from an optical measurement of said target structure.

17. A method according to clause 16, wherein the target structure comprises an alignment mark; and said parameter of interest value is an alignment position value.

18. A method according to clause 16, wherein the target structure comprises an overlay target; and said parameter of interest value is an overlay value.

19. A method according to any of clauses 16 to 18, comprising performing said optical measurement of said target structure.

20. A computer program comprising program instructions operable to perform the method of any of clauses 1 to 18, when run on a suitable apparatus.

21. A non-transient computer program carrier comprising the computer program of clause 20.

22. A processing system comprising a processor and a storage device comprising the computer program of clause 20.

23. An alignment sensor comprising a processing system according to clause 22.

24. A lithographic apparatus comprising: a patterning device support for supporting a patterning device; a substrate support for supporting a substrate; and the alignment sensor of clause 23.

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

**Claims**

1. A method for determining a measurement setting for measuring a parameter of interest from a target structure on a substrate; the method comprising:

   obtaining first position difference data describing a difference between a position of a first representative target structure position and a position of one or more first features relating to a product structure;
   obtaining optical metrology data relating to optical measurements of said target structure and further relating to a plurality of different measurement settings; and
   determining said measurement setting from said first position difference data and said optical metrology data such that a measured feature position value obtained from an optical measurement of said target structure using the determined measurement setting is expected to represent a position of said one or more first features.

2. A method as claimed in claim 1, wherein said first position difference data is obtained from direct measurement of said first representative target structure position and said position of one or more first features.

3. A method as claimed in claim 2, wherein said first position difference data comprises scanning electron microscope data and/or transmission electron microscope data.

4. A method as claimed in claim 1, 2 or 3, comprising performing first metrology on at least one substrate comprising a plurality of instances of said target structure to obtain said first position difference data.

5. A method as claimed in any preceding claim, wherein said first representative target structure position describes a center of mass position target structure, center position of the target structure, other feature position of the target structure or an average position of two or more features of the target structure.

6.   A method as claimed in any preceding claim, wherein said target structure comprises a sub-segmented target structure having a periodicity of sufficient magnitude to be resolvable by an optical metrology tool; and Sub-segmentation comprising and/or being representative of said one or more first features.

7.   A method as claimed in claim 6, wherein said first position difference data comprises measurements of a difference between a position of said sub-segmentation comprising and/or being representative of said one or more first features and said first representative target structure position.

8.   A method as claimed in any preceding claim, wherein said step of determining a measurement setting comprises determining said measurement setting to minimize a difference between second position difference data obtained from said optical metrology data and said first position difference data, wherein the second position difference data comprises a difference between a measured position obtained using the determined measurement setting with a second representative target structure position.

9.   A method as claimed in claim 8, wherein said second representative target structure position comprises an average measured position over a plurality of different measurement settings.

10.  A method as claimed in claim 9, wherein said average weighted position comprises a signal strength weighted average measured position.

11.  A method as claimed in claim 8, wherein said second representative target structure position is obtained by:

obtaining a plurality of intensity asymmetry values for each of a plurality of different illumination settings, wherein an intensity asymmetry value comprises a metric related to a difference or imbalance between the respective intensities or amplitudes of at least two complementary diffraction orders of radiation diffracted by said structure;
translating the intensity asymmetry value into a phase offset corresponding to asymmetric deviation in the alignment structure; and
determining, from the phase offset, said second representative target structure position as a position corrected for said asymmetric deviation.

12.  A method as claimed in any of claims 8 to 11, wherein said second representative target structure position corresponds to a center of mass or center position of the target structure.

13.  A method as claimed in any preceding claim, wherein each measurement setting comprises one or more of:

an illumination setting, where an illumination setting describes one or a combination of measurement wavelengths and/or one or a combination of measurement polarizations;
a weighting for one or a plurality of measurement wavelengths and/or measurement polarizations; and/or
a weighting for particular regions, pixels or groups of pixels of a measurement image.

14.  A method as claimed in any preceding claim, wherein said first position difference data and said optical metrology data all relate to metrology performed before an exposure step, the method not using any hindsight overlay metrology.

15.  A method as claimed in any preceding claim, comprising using the determined measurement setting to determine a parameter of interest value comprising and/or relating to said measured feature position value from an optical measurement of said target structure.

Fig. 1

Fig. 2

Fig. 3

Fig. 4

Fig. 5

FF

FF

SP

L$_{SS}$

(a)

(b)

Fig. 6

Europäisches
Patentamt

European
Patent Office

Office européen
des brevets

# EUROPEAN SEARCH REPORT

Application Number

EP 21 20 3273

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | US 2019/094721 A1 (TINNEMANS PATRICIUS ALOYSIUS JACOBUS [NL] ET AL) 28 March 2019 (2019-03-28) * paragraphs [0125] – [0132]; figures 8,9 * | 1-15 | INV. G03F9/00 G03F7/20 |
| A | MENCHTCHIKOV BORIS ET AL: "Reduction in overlay error from mark asymmetry using simulation, ORION, and alignment models", PROCEEDINGS OF SPIE; [PROCEEDINGS OF SPIE ISSN 0277-786X VOLUME 10524], SPIE, US, vol. 10587, 20 March 2018 (2018-03-20), pages 105870C-105870C, XP060103665, DOI: 10.1117/12.2297493 ISBN: 978-1-5106-1533-5 * section 4 * | 1-15 | |
| A | JIANMING ZHOU ET AL: "Eliminating the offset between overlay metrology and device patterns using computational metrology target design", SPIE PROCEEDINGS, vol. 9778, 8 March 2016 (2016-03-08), page 97781G, XP055678095, US DOI: 10.1117/12.2219439 ISBN: 978-1-5106-3673-6 * section 2.2 * | 1-15 | |

TECHNICAL FIELDS
SEARCHED     (IPC)

G03F

The present search report has been drawn up for all claims

| Place of search | Date of completion of the search | Examiner |
|---|---|---|
| Munich | 4 April 2022 | Weckesser, Jens |

EPO FORM 1503 03.82 (P04C01)

## ANNEX TO THE EUROPEAN SEARCH REPORT
## ON EUROPEAN PATENT APPLICATION NO.

EP 21 20 3273

This annex lists the patent family members relating to the patent documents cited in the above-mentioned European search report.
The members are as contained in the European Patent Office EDP file on
The European Patent Office is in no way liable for these particulars which are merely given for the purpose of information.

04-04-2022

| Patent document cited in search report | | Publication date | Patent family member(s) | | Publication date |
|---|---|---|---|---|---|
| US 2019094721 | A1 | 28-03-2019 | EP | 3504593 A1 | 03-07-2019 |
| | | | EP | 3627228 A1 | 25-03-2020 |
| | | | TW | 201921100 A | 01-06-2019 |
| | | | TW | 202046009 A | 16-12-2020 |
| | | | US | 2019094721 A1 | 28-03-2019 |
| | | | US | 2020081356 A1 | 12-03-2020 |
| | | | US | 2020272061 A1 | 27-08-2020 |
| | | | WO | 2019063245 A1 | 04-04-2019 |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20130258310 A
- US 20130271740 A
- WO 2013178422 A1
- US 6961116 B
- US 2015261097 A1
- US 2009195768 A
- WO 2020057900 A1
- US 20190094721 A1
- WO 2017032534 A2
- WO 2021122016 A

**Non-patent literature cited in the description**

- **LUCAS et al.** fast Fourier transform implementation of the Kramers-Kronig relations: Application to anomalous and left handed propagation. *AIP Advances,* 2012, vol. 2, 032144